# EUROPÄISCHE PATENTSCHRIFT

(11) **EP 1 074 013 B1**
(45) Veröffentlichungstag und Bekanntmachung des Hinweises auf die Patenterteilung: **22.01.2003**
(21) Anmeldenummer: 99920781.4
(22) Anmeldetag: 23.04.1999
(51) Int. Cl.: G09F 9/33, G09F 13/22, H01L 25/00

(54) **ORTSVERÄNDERLICHER INFORMATIONSTRÄGER**
TRANSPORTABLE INFORMATION-CARRYING MEDIUM
SUPPORT D'INFORMATION TRANSPORTABLE

(30) Priorität: 24.04.1998 DE 19818227
(43) Veröffentlichungstag der Anmeldung: 07.02.2001
(73) Patentinhaber: Gigavision Mediagesellschaft MBH, 12487 Berlin (DE)
(72) Erfinder: KLATT, Helmuth, D-14050 Berlin (DE)
(74) Vertreter: Pfenning, Meinig & Partner GbR
(86) Internationale Anmeldenummer: EP9902798
(87) Internationale Veröffentlichungsnummer: WO99056272

(56) Entgegenhaltungen:
- DE-A- 19 603 444
- US-A- 4 713 579
- US-A- 4 782 336
- PATENT ABSTRACTS OF JAPAN vol. 017, no. 401 (E-1404), 27. Juli 1993 (1993-07-27) & JP 05 074975 A (DENKI KAGAKU KOGYO KK), 26. März 1993 (1993-03-26)

## Beschreibung

Die Erfindung betrifft einen ortsveränderlichen Informationsträger, der insbesondere an Gebäudefassaden, Baugerüsten, Verkehrsbauten, Straßen- und Schienenfahrzeugen Verwendung findet.

Gattungsgemäße ortsveränderliche Informationsträger, wie z.B. Sichtreklamen, dienen der Werbung für Produkte und Dienstleistungen, werden aber auch zur optischen Wiedergabe von Informationen oder Hinweisen, z.B. als Verkehrsleitsysteme, als Informationsträger in öffentlichen Einrichtungen, wie Bahnhöfen, Flughäfen, etc. eingesetzt.

Zur Präsentation von sich ändernden Informationen oder Grafiken sind Leuchtschilder, Tafeln oder Paneele bekannt, die mit Glühlampen, Entladungsröhren oder anderen bekannten Leuchtmitteln ausgestattet sind.

Aus der **DE 195 39 881 A1** "Einrichtung zur Anzeige von Zeichen und Verfahren zu ihrer Herstellung" ist auch die Verwendung von Leuchtdioden bekannt, die auf einer starren Leiterplatte in geometrisch geordneter Form zueinander angeordnet sind. Als Träger der LED werden Leiterplatten verwandt, die biegesteif ausgebildet sind, um ein Verwinden der bestückten Leiterplatte im eingebauten Zustand zu verhindern. Die dichte, matrixförmige Anordnung der einzelnen Kontaktpunkte, an die bedarfsweise LED angeschlossen werden können, dient dazu, auf einer konstruktiv einheitlich gestalteten Leiterplatte eine beliebige, unikate Bestückung mit LED vornehmen zu können. Mit einer derart bestückten Platine kann daher stets nur ein immer wiederkehrendes Grafikelement, ein Buchstabe, ein Symbol, etc. lichttechnisch dargestellt werden.

Aus der **DE 32 27 959 A1** ist eine großflächige LED-Matrixanzeige bekannt, bei der die LED an den Kreuzungspunkten zweier senkrecht zueinander angeordneter, parallel verlaufender Leiterbahnen angeordnet sind. Der begrenzt flexibel ausgebildete Grundkörper ist mit Aussparungen für die Halbleiterchips und Bonddrähte versehen, die zugleich als Lichtleitschächte dienen.

Die elektrisch leitende Ebene besteht vorzugsweise aus aufgedampften, metallisch leitenden Streifen, die parallel verlaufen und zur Kontaktierung der p- oder n-seitigen Kontakte der LED dienen. Auf dem Grundkörper ist eine flexible Leiterplatte mit vorzugsweise leitendem Kleber befestigt. Diese Leiterplatte trägt die Halbleiterchips und weist ebenfalls Leitbahnen zur Kontaktierung des n- oder p-Kontaktes der LED auf. die Leitbahnen sind dabei vorzugsweise senkrecht zu den metallischen Leitbahnen des Grundkörpers ausgerichtet.

Derartige begrenzt flexible Anordnung finden Verwendung als mehrzeilige LED-Matrix an elektrischen und elektronischen Geräten und Einrichtungen. Die begrenzte Flexibilität der Leiterplatte dient dazu, eine optimale Anpassung der LED-Anzeige an die Gehäuseform eines Gerätes zu ermöglichen, in dem die matrixförmige Anzeigeeinrichtung untergebracht ist. Dadurch kann die LED-Anzeige z.B. an Krümmungen oder Wölbungen eines Gerätegehäuses optimal angepaßt werden.

Ein Einsatz dieser LED-Anzeige mit hohem Informationsgehalt im Freien scheidet aufgrund der labilen Bauweise aus. Zudem würden die hohen Fertigungskosten eine Übertragung dieser kleinflächigen LED-Matrix auf großflächige, ortsveränderliche Sichtreklamen verhindern.

Eine derartige LED-Anzeige, die wie ein begrenzt flexibles, mehrschichtiges Sandwich-Element ausgebildet ist, ist für einen Einsatz im Freien auch wegen der auftretenden Windlasten nicht einsetzbar. So müßten die einwirkenden Windlasten durch eine biegesteife Stützkonstruktion aufgenommen werden, um eine Zerstörung der LED-Anzeige zu verhindern.

Aus der **DE 36 22 560 A1** ist ein flacher Bildschirm für Fernseher und Monitore bekannt, bei der auf einer Platine matrixförmige Leuchtstoffpunkte, wie z.B. Dioden angeordnet sind, die durch ein Rasterverfahren angesteuert werden können. Auch in diesem Fall folgt eine Aufnahme der einzelnen Leuchtmittel auf einer biegesteifen Platine. Eine Übertragung dieser technischen Lösung auf großflächige Sichtreklamen für die Außenwerbung ist ebenfalls nicht möglich, da eine derartige, großflächige Platine nur mit aufwendigen mechanischen Mitteln an einer Häuserfassade sicher und vor Witterungsunbilden geschützt montiert werden könnte. Montage und Demontage einer derartigen, großflächigen Platine würde zudem den Einsatz von Hebezeugen und Hubbühnen, etc. voraussetzen. aufgrund der vergleichsweise hohen Eigenlast und der Größe einer biegesteifen Platine ist für die Montage regelmäßig der Einsatz mehrerer Montagehilfskräfte erforderlich.

Aus der **DE 41 30 844 A1** ist eine alphanumerische Anzeigeeinrichtung bekannt, bei der SMT-Leuchtdioden in Verbindung mit Lichtleitern verwendet werden. Die Lichtaustrittsöffnungen der benachbarten Lichtleiter ermöglichen dabei die optische Darstellung gleicher oder verschiedenartiger Konturen und Formen. die linienförmig aneinanderstoßenden Segmente der alphanumerischen Anzeigeeinrichtung bilden dabei eine geschlossene, homogene Oberfläche. Der Einsatz einer derartigen, großflächigen Anzeigeeinrichtung im Freien würde ebenso aus klimatischen Gründen (statische Wind- und Schneelasten, dynamische stoß- oder impulsartige Belastungen durch Windböen, etc.) scheitern.

Daneben sind konventionelle, großformatige Werbe- und Informationsträger bekannt, bei denen die Werbeflächen nach der Full-Side-Paint-Technik mit digitalen Druckmaschinen beschichtet werden. Als Trägermaterialien können feinmaschige Gewebestrukturen oder hochbelastbare Kunststoffolien zum Einsatz kommen.

Derartige Werbeträger sind bei Tageslicht und bei günstiger klimatischen Bedingungen geeignet, versagen aber bei ungenügender Beleuchtung (schattiger Standort) oder bei Schneefall bzw. Eisbesatz. Aufgrund der nicht oder nur bedingt luftdurchlässigen Trägermaterialien wirken auf die großflächigen Werbeträger extreme Windlasten, die nur durch ein zusätzliches Tragwerk sicher rund zerstörungsfrei aufgenommen und übertragen werden können.

Aufgabe der Erfindung ist es, die Nachteile des vorgenannten Standes der Technik zu eliminieren und eine großflächige, ortsveränderliche Sichtreklame zu schaffen, die unter klimatisch ungünstigen Bedingungen eine Anzeige gleichbleibender oder sich ändernder Informationen, Graphiken, etc. ermöglicht. Die ortsveränderliche Sichtreklame soll mit einfachen Mitteln an Hausfassaden, Baugerüsten, Kranen, Brücken, etc. oder an schienenlosen bzw. schienengebundenen Transportmitteln, insbesondere an Güterwagen oder Lkw-Trailern mit einfachen Mitteln ohne Verwendung von Hebezeugen anordenbar sein. Die Montage und Demontage der ortsveränderlichen Sichtreklame soll innerhalb kürzester Fristen auch durch ungeschultes Personal möglich sein. Ebenso soll die ortsveränderliche Sichtreklame im demontierten Zustand platz- und raumsparend zwischengelagert werden können.

Die erfindungsgemäße Aufgabe wird gelöst durch die Merkmale des Hauptanspruches. Vorzugsweise Weiterbildungen sind in den abhängigen Unteransprüchen dargelegt.

Die ortsveränderliche Sichtreklame besteht aus einer Flachleitermatrix mit offener Netzstruktur, wobei die sich in den Knoten 3 berührenden Flachleiter 1, 2 durch Leuchtmittel 4, vorzugsweise Licht emittierende Dioden, elektrisch leitend miteinander verbunden sind.

Die Flachleiter 1, 2 sind vorzugsweise als kaltgewalzte Foliendrähte ausgebildet. In einer alternativen Gestaltungsform besteht die netzförmige Matrix aus endlos gefertigten Leiterbahnen.

Die Verbindung der Leuchtmittel 4 mit den Flachleitern 1, 2 an den Kreuzungspunkten [Knoten 3] erfolgt mit Hilfe bekannter Füge- oder Montagetechnologien. Die elektrisch leitende Verbindung der Flachleiter 1, 2 mit den Leuchtmitteln 4 wird vorzugsweise durch Ultraschall-Schweißen, Walzen, Kleben, Vernieten, Crimpen oder mittels thermischer Verbindungsverfahren hergestellt. Die Anordnung der Leuchtmittel 4 erfolgt vorzugsweise äquidistant an oder auf den Knoten 3 der Netzstruktur. Durch die gleichbeabstandeten Leuchtmittel 4 können Grafiken optimal dargestellt werden. Zudem wird bei dieser bevorzugten Ausgestaltung der Aufwand für die Fertigung der Netzmatrix minimiert.

Das elektrisch leitende, netzförmige System kann durch die Verwendung flexibler Leiter, insbesondere von kaltgewalzten oder kaltgezogenen Flachleitern, leicht auf- und ausgerollt werden. Durch die vorzugsweise Verwendung von kaltgewalzten Flachleitern wird eine Biegewechselfestigkeit von mehreren Millionen Lastspielen erreicht, so daß ein mehrjähriger Einsatz der netzförmigen Sichtreklame im Freien problemlos möglich ist. Den gleichen Vorteil erzielt man, wenn die einzelnen Flachleiter aus hochflexiblen Litzen, d.h. verseilten Drähten bestehen.

Die Größe des Netzes kann in den Abmessungen frei gestaltet werden, da durch die elektronische Ansteuerung der Leuchtmittel, insbesondere der lichtemittierenden Dioden, beliebige Grafiken generiert werden können.

Die Maschenweite 8 der Matrix mit den, in den Knoten 3 angeordneten Leuchtmitteln 5 kann je nach der gewünschten Auflösung, der grafischen Informationsdichte und dem Anwendungsfall (Betrachtungsabstand, Lichtverhältnisse, etc.) quasi beliebig erweitert werden. Die Maschenweite 8 beträgt in Abhängigkeit von der Auflösung und als Funktion des Betrachtungsabstandes vorzugsweise etwa 10 x 10 mm bis ca. 160 x 160 mm; sie kann jedoch bis auf die jeweilige Breite der Flachleiter 1,2 reduziert werden, so daß diese praktisch abstandslos nebeneinander liegen, oder sie kann maximal bis zu einer Größe von 250 x 250 mm erweitert werden.

Zur Erhöhung der mechanischen Festigkeit ist die, durch die sich berührenden Flachleiter 1, 2 gebildete netzförmige Matrix in einer bevorzugten Ausbildung wie ein Gewebe (mit Kett- und Schlußfaden) strukturiert.

Zur weiteren Erhöhung der Reißfestigkeit des Flachleiters wird während der Herstellungsphase ein hochreißfester Werkstoff (z.B. Kevlar) mit einlaminiert. Dieser Vorgang läßt sich unmittelbar in den Herstellungsprozeß der Flachleiter integrieren, indem vor dem Laminieren des flachen Kupferleiters mit Isolationsschichten ein parallel dazu angeordneter flexibler, hochreißfester Werkstoff in Fadenform eingefügt wird.

Der Netzknoten besteht vorzugsweise aus zwei sich orthogonal kreuzenden, elektrisch isolierten Flachleitern 1, 2. Die Leiter können aber auch unter beliebigen Winkeln angeordnet werden, um die Form des Netzes dem Einsatzgebiet anzupassen (z.B. rauten- oder trapezförmige Maschen, um einwirkende Kräfte aufnehmen und weiterleiten zu können.

Um Schnee- und Eisansatz zu verhindern, ist es notwendig, die gesamte Netzstruktur auf eine Temperatur > = 0°C zu erwärmen. Dies wird bevorzugt durch einen weiteren Leiterzug realisiert, der parallel zu den jeweiligen Leiterzügen der Leiter 1, 2 in die vorzugsweise vertikalen und horizontalen Flachleiter einlaminiert ist. Dieser weitere Leiterzug, der als Heizleiter 1h, 2h wirkt, ist von seinem Leistungsquerschnitt so dimensioniert, daß bei einer gewollten Überhöhung der Stromdichte der Leiter erwärmt wird. durch eine Verbindung der Heizleiter 1h, 2h untereinander und mit einer Energieversorgungseinrichtung wird bewirkt, daß jeder Leiter des matrixförmigen Netzes erwärmt wird.

Durch entsprechende Temperaturfühler und elektrische Regelschaltungen kann das Netz schnee- und eisfrei gehalten werden und somit unabhängig von den Witterungsbedinungen seine bestimmungsgemäße Funktion erfüllen.

Ein weiterer Vorteil der Anordnung besteht darin, daß das Leitungsnetz mit den darin eingebundenen Leuchtmitteln 4 beliebig oft an andere Standorte verbracht werden kann. Dadurch kann die ortsveränderliche Sichtreklame im Wohn- oder Gesellschaftsbau bei Neubau- und Sanierungsvorhaben zeitlich befristet als Werbemittel an Gebäudefassaden bzw. Baugerüsten angeordnet werden.

Aufgrund der geringen Eigenmasse, die aus der offenen Netzstruktur und der vorzugsweisen Verwendung dünnwandiger Flachleiter 1, 2 resultiert, stellt die Sichtreklame keine zusätzliche mechanische Belastung für eine Fassade oder ein Baugerüst dar, das beispielsweise als Träger fungiert.

Wegen der weitmaschigen, offenen Netzstruktur sind auch die zusätzlichen statischen und dynamischen Belastungen des Baugerüstes oder eines anderen Trägers durch Wind und Schnee vernachlässigbar gering.

In einer vorzugsweisen Weiterbildung sind die ummantelten Leiter 1, 2 mit einem außenliegenden Heizdraht oder einem gleichwirkenden Mittel umgeben. Dadurch kann im Winter ein Besatz der Leiter 1, 2 mit Schnee verhindert und somit die mechanische Belastung des Netzes minimiert werden. Gleichzeitig wird die Ausbildung eines Eispanzers auf den LED verhindert, so daß die visuelle Wahrnehmbarkeit der Informationen auf der ortsveränderlichen Sichtreklame auch im Winter nicht beeinträchtigt wird.

Durch die vorzugsweise Verwendung von Flachleitern wird zudem eine höhere Zugfestigkeit gegenüber konventionellen Rundleitern erzielt. Dadurch können die Leiterquerschnitte gegenüber vergleichbaren Rundleitern minimiert werden.

Aufgrund der hohen mechanischen Belastbarkeit der flexiblen, netzförmigen Sichtreklame kann die Einrichtung unmittelbar als ergänzendes oder alternatives Schutzmittel an Baugerüsten angeordnet werden, um z.B. Passanten vor herabfallenden Gegenständen zu schützen. Dazu weist das matrixförmige Netz in einer vorzugsweisen Ausgestaltung reißfeste Fäden auf, die gemeinsam mit den Flachleitern in die umhüllende Isolation integriert sind. Vorzugsweise werden extrem zugfeste Fäden aus Kevlar in die Isolation einlaminiert.

Die vorgeschlagene Flachleitermatrix mit offener Netzstruktur kann bevorzugt in der visuellen Außenwerbung eingesetzt werden.

Aufgrund der geringen Fertigungskosten, der unterschiedlichen Einsatzmöglichkeiten und der variablen Darstellbarkeit von Grafiken oder Videosequenzen (movies) verkörpert diese Lösung eine Alternative zu den konventionellen großflächigen Werbemitteln, wie bedruckten Planen, Leinwänden, etc.

Vorteilhaft anwendbar ist die ortsveränderliche Sichtreklame auch im Bereich der Verkehrslenkung und - leitung. so können die Verkehrsteilnehmer mit einfachen Mitteln auf Verkehrsmagistralen und Autobahnen z.B. auf sich ändernde Verkehrssituationen (Warnung vor Staus, Hinweis auf Nebelbänke, etc.) hingewiesen werden. Die notwendige Erfassung und Aufbereitung der notwendigen meteorologischen Daten kann vor Ort durch eine autonome Datenverarbeitungseinrichtung erfolgen. Die Informationen können ebenso drahtlos über Funknetze an die Verkehrsleiteinrichtung übertragen und dort decodiert und grafisch umgesetzt werden.

Durch den bevorzugten Einsatz farbiger LED können vorteilhaft mehrfarbige Grafiken dargestellt werden. Die verwendeten lichtemittierenden Dioden mit mindestens zwei unabhängigen integrierten Diodensystemen (M-LED) erlauben eine diskrete Einzelansteuerung jedes einzelnen Diodensystems, so daß eine oder mehrere Grundfarben erzeugt werden können. Durch die Farbmischung können quasi unendlich viele Spektralfarben erzeugt werden. Um die einzelnen Diodensysteme einer M-LED diskret steuern zu können, weisen die, die Flachleitermatrix bildenden Leiter 1 und 2 mindestens drei gegeneinander isolierte elektrische Leiterzüge auf. Die vorzugsweise parallel zueinander verlaufenden, eng beabstandeten, isolierten Leiterzüge, die als Flachkabel ausgebildet sind, sind in den Knotenpunkten des matrixförmigen Netzes miteinander kraftleitend verbunden.

Die in den Knoten fixierten ein- oder mehrfarbigen lichtemittierenden Dioden (LED); M-LED) sind vorzugsweise auswechselbar. Dadurch kann bei mechanischen oder elektrischen Zerstörungen einzelner Leuchtmittel rasch ein Wechsel der defekten LED bzw. M-LED vorgenommen werden.

Vorzugsweise werden als M-LED Rot-Grün-Blau-Lichtemitter-Dioden (RGB-LED) verwendet. Dadurch ist eine quasi stufenlose Erzeugung aller Spektralfarben im Bereich des sichtbaren Lichtes möglich.

Die matrixförmige Anordnung der Flachleiter 1, 2 ermöglicht eine individuelle diskrete Ansteuerung jedes einzelnen, mit einem Leuchtmittel 4 versehenen Knotens 3 innerhalb der Matrix.

Die Ansteuerung erfolgt mit bekannten Mitteln, insbesondere durch einen Mikrorechner oder durch einen Multiplexer. Mit dieser Anordnung besteht die Möglichkeit, konstante oder sich ändernde Informationen (Texte, Grafiken, Videosequenzen) großflächig darzustellen.

Aufgrund der geringen Trägheit und der geringen Leistungsaufnahme der vorzugsweise verwendeten LED bzw. M-LED können insbesondere sich ständig ändernde Text- oder Bildinhalte verzögerungsfrei graphisch dargestellt werden.

Die Maschenweite 8 als der durchschnittliche Abstand benachbarter Leiter 1 - 1 bzw. 2 - 2 richtet sich nach dem jeweiligen Verwendungszweck der netzförmigen Matrix. Bei vergleichsweise geringem Abstand des Betrachters zur Oberfläche der aufgespannten Matrix beträgt der Abstand der vorzugsweise parallel zueinander angeordneten Leiter 1 bzw. 2 etwa 10 bis 25 mm. Beim Einsatz einer netzförmigen Matrix in der Außenwerbung, z.B. am Tragwerk einer Autobahnbrücke, beträgt der mittlere Abstand etwa 50 bis 175 mm.

Die Struktur der Flachleitermatrix der ortsveränderlichen Sichtreklame kann ebenfalls an die Form des Objektes angepaßt werden, an dem die Sichtreklame zum Einsatz gelangt. So kann die Netzstruktur beispielsweise fächerförmig ausgebildet sein, um eine konturengenaue Anpassung an einem halbkreisförmigen Träger eines Tragwerkes zu ermöglichen.

Falls die ortsveränderliche Sichtreklame an Baugerüsten verwendet wird und zugleich Sicherheitsfunktionen übernehmen soll, besteht die Möglichkeit, die Struktur der Flachleitermatrix wie ein textiles, gewebeartiges Flechtwerk mit Kett- und Schußfäden auszubilden. Zusätzlich können die sich berührenden Leiter in den Knotenpunkten miteinander durch Druck, Temperatur, Klebstoff, etc. verbunden werden, um die mechanische Festigkeit zu erhöhen.

Bei engmaschigen Flachleitermatritzen besteht auch die Möglichkeit, nicht alle elektrischen Flachleiter 1, 2 und/oder Knoten 3 mit Leuchtmitteln zu bestükken, sofern aufgrund des horizontalen bzw. vertikalen Abstandes zu jeweils benachbarten Leuchtmitteln noch einer hinreichenden Auflösung der sichtbar gemachten Grafiken ermöglicht wird.

Dadurch werden die Fertigungskosten wegen der signifikant reduzierten Anzahl verwendeter Leuchtmittel deutlich reduziert. Die nicht mit Leuchtmitteln ausgerüsteten Leiter dienen in diesem Fall lediglich zur Aufnahme von Kräften, insbesondere von Wind- und Schneelasten

Die als Leuchtmittel vorzugsweise verwendeten LED bzw. M-LED werden durch bekannte Stromquellen mit Energie versorgt. Die Größe des Lichtstromes, die Frequenz oder der Kurvenverlauf der erzeugten Ströme, mit denen die einzelnen LED bzw. die diskret ansteuerbaren Dioden der M-LED beaufschlagt werden, sind über einen Computer oder Multiplexer oder ein gleichwirkendes System steuerbar.

Ein weiterer Vorteil der Anordnung besteht in der Verwendung von Kleinstspannungen, mit denen die LED betrieben werden. Dadurch ist eine Gefährdung von Personen während der Montage und Demontage sowie während des Betriebes der netzförmigen, ortsveränderlichen Sichtreklame ausgeschlossen. Durch die Verwendung von Kleinspannungen kann die netzförmige Matrix auch als Werbemittel an der Karosserie oder den Planen von Nutzkraftfahrzeugen angeordnet werden. Aufgrund des geringen Energiebedarfs kann die Stromversorgung ohne zusätzliche Mittel über das Bordnetz des jeweiligen Kraftfahrzeuges erfolgen.

Die Erfindung ist nachfolgend in mehreren Ausführungsbeispielen beschrieben und in zugehörigen Zeichnungen dargestellt.

**Ausführungsbeispiel 1** beschreibt die Verwendung der netzförmigen, ortsveränderlichen Sichtreklame als großformatige Informationsanzeige an einer Brückenkonstruktion, die eine Autobahn überquert.

Über die Informationsanzeige erhalten die Verkehrsteilnehmer kontinuierlich oder zyklisch Informationen über die zu erwartenden Fahrbahnbedingungen, die Sichtverhältnisse und die momentane Verkehrsdichte. Die Ermittlung der aktuellen klimatischen Umgebungsbedingungen am Standort der Informationsanzeige, deren Auswertung und visuelle Darstellung auf der Anzeige, erfolgt über einen autonomen Mikrorechner, der mit entsprechenden Meßeinrichtungen in Wirkverbindung steht. Die Energieversorgung des Gesamtsystems erfolgt durch wiederaufladbare Speicherakkumulatoren in Verbindung mit Einrichtungen zur Nutzung regenerativer Energiequellen (Windenergie, Sonnenenergie).

Neben Sachinformationen können Werbeinformationen oder -grafiken optisch werbewirksam dargestellt werden (werblicher Hinweis auf nächste Tankstelle, Rasthaus, etc.).

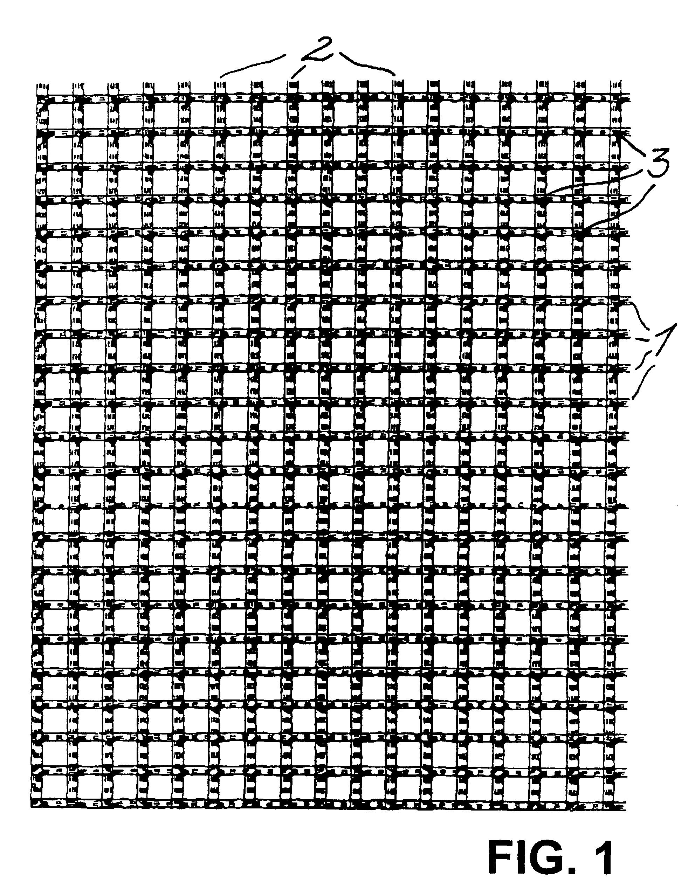

- Fig. 1: zeigt in einer vereinfachten Darstellung die Struktur der äquidistanten Matrix, bestehend aus n horizontalen und m vertikalen Flachleitern 1, 2.
Auf eine gesonderte Darstellung der Energieversorgungseinrichtung und der Einrichtung zur Ansteuerung der Leuchtmittel wurde der besseren Übersichtlichkeit halber verzichtet.

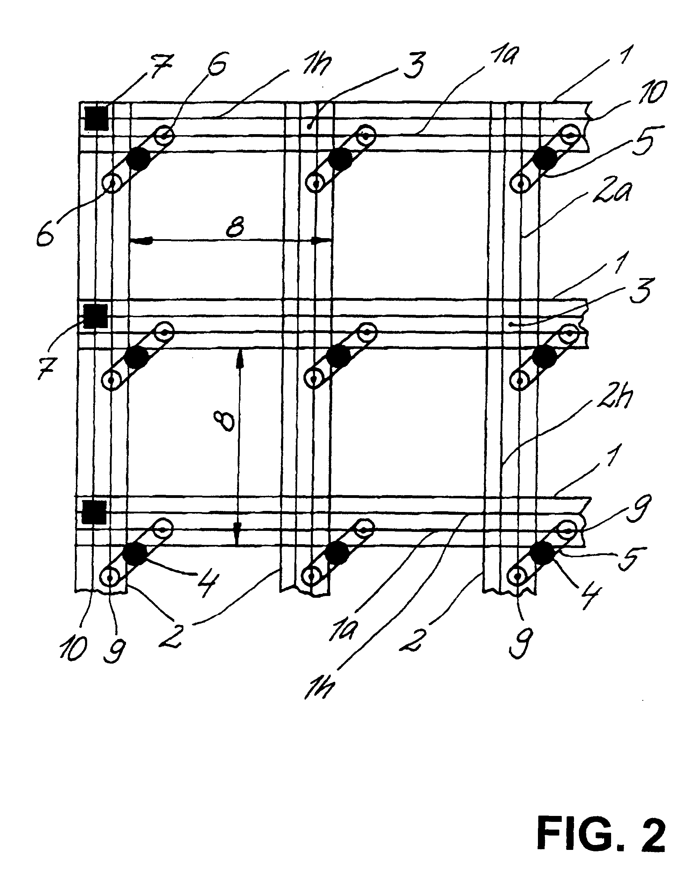

- Fig. 2: zeigt in einer vergrößerten, gleichfalls schematisierten Darstellung eine Einzelheit der netzförmigen Matrix.

Die Maschenweite des Netzes beträgt 35 mm x 35 mm. An den Knotenpunkten der sich kreuzenden Leiter 1 und 2 sind durch Crimpen monochromatische Lichtemitter-Dioden (LED) mit den gegeneinander isolierten Leiterbahnen der elektrischen Leiter 1 und 2 elektrisch leitend verbunden.

Ein benachbarter zweiter Leiter ist als Heizleiter 1h, 2h ausgeführt. Der Heizleiter 1h, 2h ist ebenfalls als Flachleiter ausgebildet und sein Leitungsquerschnitt so dimensioniert, daß durch die erhöhte Stromdichte des durchflossenen Leiters dieser erwärmt wird. Dadurch kann bereits prophylaktisch ein Schneeoder Eisbesatz der Matrix verhindert werden. Die Ansteuerung der Heizleitung 1h, 2h erfolgt vorzugsweise über den Mikrorechner bzw. den Multiplexer, der mit einer Temperaturüberwachungseinheit in Wirkverbindung steht und in Abhängigkeit von der absoluten Umgebungstemperatur oder von der Temperaturänderungsgeschwindigkeit ΔT/dt eine Ansteuerung der Heizleiter bewirkt.

In einem **zweiten Ausführungsbeispiel** wird die ortsveränderliche Sichtreklame für die Schaufensterwerbung in den Innenräumen von Verkaufseinrichtungen eingesetzt. Die Sichtreklame dient in diesem Fall der direkten Information des Kunden, z.B. über geänderte Ladenöffnungszeiten der Verkaufseinrichtung oder über spezielle Sonderangebote.

Durch die offene Netzstruktur und der geringen Masse der freiprogrammierbaren Sichtreklame ist es möglich, diese mit einfachen Mitteln hinter einer Schaufensterscheibe der Verkaufseinrichtung aufgespannt zu installieren. Der Aufmerksamkeitseffekt der illuminierten Schaufensterauslage kann durch werbewirksame Videosequenzen oder Grafiken gesteigert werden. Dadurch werden insbesondere flüchtige Passanten animiert, sich der Schaufensterauslage zuzuwenden.

Aufgrund der offenmaschigen Struktur der Sichtreklame kann der unmittelbar vor der Schaufensterscheibe stehende Betrachter ungehindert die Exponate der Schaufensterauslage in Augenschein nehmen, wird jedoch bei einem größeren Betrachtungsabstand von der Lichtgrafik optisch eingefangen. Neben beliebig zu gestaltenden Lichteffekten lassen sich Bilder als auch Texte darstellen, die bedarfsweise durch akustische Einspielungen in ihrer Aussage unterstützt werden können und schaffen somit eine neue Prächtigkeit in Werbung und Kommunikation.

Um die Aufmerksamkeit von Passanten zu erregen, werden als Leuchtmittel Rot-Grün-Blau-Lichtemitter-Dioden (RGB-LED) verwendet. Dadurch ist eine quasi stufenlose Erzeugung aller Spektralfarben an allen M-LED möglich. Die M-LED befinden sich an den Knotenpunkten der netzförmigen Matrix. Zur individuellen Ansteuerung jedes der drei Diodensysteme einer RGB-LED weisen die Flachleiter 1, 2 jeweils drei gegeneinander und gegen Masse isolierte Leiterzüge auf. Die einzelnen Pins der RGB-LED sind im Knotenbereich mit den zugehörigen Leiterzügen elektrisch leitend verbunden. Die gewünschte Lichtdichte kann in Abhängigkeit von den Lichtverhältnissen der Umgebung durch die Auswahl geeigneter M-LED (Mikro-LED, Mini-LED, Jumbo-LED) beeinflußt werden.

Ein signifikanter Vorteil der netzförmigen Matrix besteht bei diesem Beispiel in der Möglichkeit der schnellen Montage und Demontage dieses flexiblen Werbemittels sowie im geringen Flächen- und Raumbedarf bei einer zeitlich befristeten Zwischenlagerung.

Aufgrund dieser Eigenschaften können beispielsweise Handelsketten eine derartige mobile Sichtreklame nach mehrtägigem bzw. mehrwöchigem Einsatz in einer Verkaufseinrichtung in einer nächsten Filiale installieren, um Monotonieerscheinungen bei den umworbenen Dauerkunden entgegenzuwirken.

Zur Erhöhung der mechanischen Festigkeit des Informationsträgers ist es auch möglich, die Flachleitermatrix elektrisch isoliert auf eine geschlossene flexible Folie aufzubringen.

## Patentansprüche

1. Ortsveränderlicher Informationsträger, insbesondere zur Verwendung als Sichtreklame an Gebäudefassaden, Baugerüsten, Verkehrsbauten, Straßenund Schienenfahrzeugen, bestehend aus einer Flachleitermatrix mit offener Netzstruktur, die aus ummantelten Flachleitern (1, 2) gebildet wird,
weiterhin bestehend aus Leuchtmitteln (4), die mit den Versorgungsleitern (1a, 2a) im Bereich der Knoten (3) der Flachleitermatrix elektrisch leitend verbunden sind, wobei die Flachleitern (1, 2) in den Knoten kraftübertragend miteinander verbunden sind.

2. Ortsveränderlicher Informationsträger nach Anspruch 1,
**dadurch gekennzeichnet,**
**daß** die ummantelten Flachleiter (1, 2) als kaltgewalzte oder kaltgezogene Foliendrähte (Folienleiter) ausgebildet sind.

3. Ortsveränderlicher Informationsträger nach Anspruch 1 oder 2, **dadurch gekennzeichnet, daß** die Leuchtmittel (4) mit den Versorgungsleitern (1a, 2a) im Bereich der Knoten (3) durch Ultraschall-Schweißverbindungen verbunden sind.

4. Ortsveränderlicher Informationsträger nach Anspruch 1 oder 2, **dadurch gekennzeichnet, daß** die Leuchtmittel (4) mit den Versorgungsleitern (1a, 2a) im Bereich der Knoten (3) durch Warmwalzen verbunden sind.

5. Ortsveränderlicher Informationsträger nach Anspruch 1 oder 2, **dadurch gekennzeichnet, daß** die Leuchtmittel (4) mit den Versorgungsleitern (1a, 2a) im Bereich der Knoten (3) durch Crimpverbindungen verbunden sind.

6. Ortsveränderlicher Informationsträger nach Anspruch 1 oder 2, **dadurch gekennzeichnet, daß** die Leuchtmittel (4) mit den Versorgungsleitern (1a, 2a) im Bereich der Knoten (3) durch Klebeverbindungen verbunden sind.

7. Ortsveränderlicher Informationsträger nach Anspruch 1 oder 2, **dadurch gekennzeichnet, daß** die Leuchtmittel (4) mit den Versorgungsleitern (1a, 2a) im Bereich der Knoten (3) durch Nietverbindungen verbunden sind.

8. Ortsveränderlicher Informationsträger nach Anspruch 1 oder 2, **dadurch gekennzeichnet, daß** die Leuchtmittel (4) äquidistant an oder auf den Knoten (3) der Flachleitermatrix angeordnet sind.

9. Ortsveränderlicher Informationsträger nach Anspruch 1 bis 8, **dadurch gekennzeichnet, daß** als Leuchtmittel (4) Lichtemitterdioden (LED) verwendet werden.

10. Ortsveränderlicher Informationsträger nach Anspruch 1 bis 8, **dadurch gekennzeichnet, daß** als Leuchtmittel (4) mehrfarbige lichtemittierende Dioden (M-LED) verwendet werden.

11. Ortsveränderlicher Informationsträger nach Anspruch 10, **dadurch gekennzeichnet, daß** als mehrfarbige lichtemittierende Dioden (M-LED) Rot-Grün-Blau-Lichtemitter-Dioden (RGB-LED) verwendet werden.

12. Ortsveränderlicher Informationsträger nach einem der Ansprüche 1 bis 11, **dadurch gekennzeichnet, daß** die auf Trägern (5) angeordneten Leuchtmittel (4) auswechselbar sind.

13. Ortsveränderlicher Informationsträger nach einem der Ansprüche 1 bis 12, **dadurch gekennzeichnet, daß** die Maschenweite (8) der Matrix bis 250 x 250 mm beträgt.

14. Ortsveränderlicher Informationsträger nach einem der Ansprüche 1 bis 13, **dadurch gekennzeichnet, daß** die minimale Maschenweite (8) der Matrix der jeweiligen Breite der Flachleiter (1, 2) entspricht.

15. Ortsveränderlicher Informationsträger nach einem der Ansprüche 1 bis 14, **dadurch gekennzeichnet, daß** die Flachleitermatrix gewebeförmig strukturiert ist.

16. Ortsveränderlicher Informationsträger nach einem der Ansprüche 1 bis 15, **dadurch gekennzeichnet, daß** in die Flachleitermatrix ein hochreißfester Werkstoff integriert ist.

17. Verfahren zur Herstellung eines ortsveränderlichen Informationsträgers nach Anspruch 16, **dadurch gekennzeichnet, daß** bei der Fertigung der Flachleiter (1, 2) vor dem Laminieren des flachen Kupferleiters mit Isolationsschichten ein parallel dazu angeordneter flexibler, hochreißfester Werkstoff in Fadenform eingefügt wird.

18. Ortsveränderlicher Informationsträger nach einem der Ansprüche 1 bis 16, **dadurch gekennzeichnet, daß** die Flachleiter (1, 2) sich im Bereich der Knoten (3) orthogonal kreuzen.

19. Ortsveränderlicher Informationsträger nach einem der Ansprüche 1 bis 18, **dadurch gekennzeichnet, daß** die Flachleiter (1, 2) eine rautenförmige oder trapezförmige Maschenform bilden.

20. Ortsveränderlicher Informationsträger nach einem der Ansprüche 1 bis 19, **dadurch gekennzeichnet, daß** die Flachleiter (1, 2) integrierte Heizleiter (1h, 2h) aufweisen.

21. Ortsveränderlicher Informationsträger nach einem der Ansprüche 1 bis 20, **dadurch gekennzeichnet, daß** die Flachleiter (1, 2) von gesonderten, außenliegenden Heizleitern umgeben sind.

22. Ortsveränderlicher Informationsträger nach einem der Ansprüche 1 bis 21, **dadurch gekennzeichnet, daß** die Matrix der Flachleiter (1, 2) fächerförmig ausgebildet ist.

23. Ortsveränderlicher Informationsträger nach einem der Ansprüche 1 bis 22, **dadurch gekennzeichnet, daß** die Flachleitermatrix auf einer geschlossenen flexiblen Folie elektrisch isoliert aufgebracht ist.

24. Ortsveränderlicher Informationsträger nach einem der Ansprüche 1 bis 23, **dadurch gekennzeichnet, daß** die Flachleiter (1, 2) aus hochflexiblen Litzen bestehen.

## Claims

1. Transportable information carrying medium, especially for use as a visual advertisement on building facades, scaffolding, road structures, road and rail vehicles, consisting of a flat conductor matrix with an open grid structure, which is formed from sheathed flat conductors (1, 2),
further consisting of light-emitting means (4), which are connected in an electrically conductive manner with the supply conductors (1a, 2a) in the area of the nodes (3) of the flat conductor matrix, the flat conductors (1, 2) in the nodes being connected to each other in a power transmitting manner.

2. Transportable information carrying medium under Claim 1, which is **characterized in that** the sheathed flat conductors (1, 2) are formed as cold-rolled or cold-drawn foil wires (foil conductors).

3. Transportable information carrying medium under Claim 1 or 2, which is **characterized in that** the light-emitting means (4) are connected by ultrasonic weld connections with the supply conductors (1 a, 2a) in the area of the nodes (3).

4. Transportable information carrying medium under Claim 1 or 2, which is **characterized in that** the light-emitting means (4) are connected to the supply conductors (1 a, 2a) in the area of their nodes (3) by hot rolling.

5. Transportable information carrying medium under Claim 1 or 2, which is **characterized in that** the light-emitting means (4) are connected to the supply conductors (1a, 2a) in the area of their nodes (3) by crimped connectors.

6. Transportable information carrying medium under Claim 1 or 2, which is **characterized in that** the light-emitting means (4) are connected to the supply conductors (1 a, 2a) in the area of their nodes (3) by adhesive connectors.

7. Transportable information carrying medium under Claim 1 or 2, which is **characterized in that** the light-emitting means (4) are connected to the supply conductors (1 a, 2a) in the area of their nodes (3) by riveted connectors.

8. Transportable information carrying medium under Claim 1 or 2, which is **characterized in that** the light-emitting means (4) are arranged equidistant to or on the nodes (3) of the flat conductor matrix.

9. Transportable information carrying medium under Claim 1 to 8, which is **characterized in that** light-emitting diodes (LED) are used as the light-emitting means (4).

10. Transportable information carrying medium under Claim 1 to 8, which is **characterized in that** multi-colored light-emitting diodes (M-LED) are used as the light-emitting means (4).

11. Transportable information carrying medium under Claim 10, which is **characterized in that** red-green-blue light-emitting diodes (RGB-LED) are used as the multi-colored light-emitting diodes (M-LED).

12. Transportable information carrying medium under one of the Claims 1 to 11, which is **characterized in that** the light-emitting means (4) arranged on carriers (5) can be replaced.

13. Transportable information carrying medium under one of the Claims 1 to 12, which is **characterized in that** the mesh width (8) of the matrix is up to 250 x 250 mm.

14. Transportable information carrying medium under one of the Claims 1 to 13, which is **characterized in that** the minimum mesh width (8) of the matrix corresponds to the particular width of the flat conductors (1, 2).

15. Transportable information carrying medium under one of the Claims 1 to 14, which is **characterized in that** the flat conductor matrix is constructed in a woven form.

16. Transportable information carrying medium under one of the Claims 1 to 14, which is **characterized in that** a highly tear-resistant material is integrated into the flat conductor matrix.

17. Process for the manufacture of a transportable information-carrying medium under Claim 16, which is **characterized in that** during manufacture of the flat conductors (1, 2), before lamination of the flat copper conductor with insulating layers, a flexible, highly tear-resistant filiform material is inserted, running parallel to it.

18. Transportable information carrying medium under one of the Claims 1 to 16, which is **characterized in that** the flat conductors (1, 2) intersect orthogonally in the area of their nodes (3).

19. Transportable information carrying medium under one of the Claims 1 to 18, which is **characterized in that** the flat conductors (1, 2) form a lozenge shaped or trapezoidal mesh.

20. Transportable information carrying medium under one of the Claims 1 to 19, which is **characterized in that** the flat conductors (1, 2) have integral heating conductors (1h, 2h).

21. Transportable information carrying medium under one of the Claims 1 to 20, which is **characterized in that** the flat conductors (1, 2) are surrounded by separate, external heating conductors.

22. Transportable information carrying medium under one of the Claims 1 to 21, which is **characterized in that** the matrix for the flat conductors (1, 2) is formed in a fan shape.

23. Transportable information carrying medium under one of the Claims 1 to 22, which is **characterized in that** the flat conductor matrix is mounted, electrically insulated, on a closed, flexible sheet.

24. Transportable information carrying medium under one of the Claims 1 to 23, which is **characterized in that** the flat conductors (1, 2) consist of highly flexible wires.

## Revendications

1. Support d'information transportable, en particulier destiné à une utilisation en tant que publicité visuelle sur des façades de bâtiment, des échafaudages, des bâtiments de la circulation, des véhicules automobiles et sur rails, composé d'une matrice de conducteurs plats présentant une structure en réseau ouverte, qui est formée à partir de conducteurs plats guipés (1, 2),
composé en outre de moyens lumineux (4) qui sont reliés par conduction électrique avec les conducteurs d'alimentation (1a, 2a) dans la zone des noeuds (3) de la matrice de conducteurs plats, les conducteurs plats (1, 2) des noeuds étant reliés entre eux par transmission de force.

2. Support d'information transportable selon la revendication 1, **caractérisé en ce que** les conducteurs plats guipés (1, 2) sont conçus en tant que câbles en nappe (conducteurs en nappe) laminés à froid ou étirés à froid.

3. Support d'information transportable selon la revendication 1 ou 2, **caractérisé en ce que** les moyens lumineux (4) sont reliés aux conducteurs d'alimentation (1a, 2a) dans la zone des noeuds (3) par soudage aux ultrasons.

4. Support d'information transportable selon la revendication 1 ou 2, **caractérisé en ce que** les moyens lumineux (4) sont reliés aux conducteurs d'alimentation (1a, 2a) dans la zone des noeuds (3) par laminage à chaud.

5. Support d'information transportable selon la revendication 1 ou 2, **caractérisé en ce que** les moyens lumineux (4) sont reliés aux conducteurs d'alimentation (1a, 2a) dans la zone des noeuds (3) par liaisons par sertissage.

6. Support d'information transportable selon la revendication 1 ou 2, **caractérisé en ce que** les moyens lumineux (4) sont reliés aux conducteurs d'alimentation (1a, 2a) dans la zone des noeuds (3) par collage.

7. Support d'information transportable selon la revendication 1 ou 2, **caractérisé en ce que** les moyens lumineux (4) sont reliés aux conducteurs d'alimentation (1a, 2a) dans la zone des noeuds (3) par liaison par assemblage riveté.

8. Support d'information transportable selon la revendication 1 ou 2, **caractérisé en ce que** les moyens lumineux (4) sont disposés au niveau de ou sur les noeuds (3) de la matrice de conducteurs plats d'une façon équidistante.

9. Support d'information transportable selon la revendication 1 à 8, **caractérisé en ce que** l'on utilise en tant que moyens lumineux (4) des diodes luminescentes (LED).

10. Support d'information transportable selon la revendication 1 à 8, **caractérisé en ce que** l'on utilise en tant que moyens lumineux (4) des diodes luminescentes à plusieurs couleurs.

11. Support d'information transportable selon la revendication 10, **caractérisé en ce que** l'on utilise en tant que diodes luminescentes à plusieurs couleurs des diodes luminescentes rouge-vert-bleu (RVB).

12. Support d'information transportable selon l'une des revendications 1 à 11, **caractérisé en ce que** les moyens lumineux (4) disposés sur des supports (5) sont remplaçables.

13. Support d'information transportable selon l'une des revendications 1 à 12, **caractérisé en ce que** la largeur des mailles (8) de la matrice va jusqu'à 250 x 250 mm.

14. Support d'information transportable selon l'une des revendications 1 à 13, **caractérisé en ce que** la largeur minimale des mailles (8) de la matrice correspond à la largeur respective des conducteurs plats (1, 2).

15. Support d'information transportable selon l'une des revendications 1 à 14, **caractérisé en ce que** la matrice de conducteurs plats est structurée à la façon d'un tissu.

16. Support d'information transportable selon l'une des revendications 1 à 15, **caractérisé en ce qu'**un matériau à haute résistance à la rupture est intégré dans la matrice de conducteurs plats.

17. Procédé de fabrication d'un support d'information transportable selon la revendication 16, **caractérisé en ce que**, lors de la fabrication des conducteurs plats (1, 2), avant la stratification du conducteur en cuivre plat avec des couches isolantes, un matériau flexible, à haute résistance à la rupture et disposé parallèlement, est inséré sous la forma de fils.

18. Support d'information transportable selon l'une des revendications 1 à 16, **caractérisé en ce que** les conducteurs plats (1, 2) se coupent à angle droit dans la zone des noeuds (3).

19. Support d'information transportable selon l'une des revendications 1 à 18, **caractérisé en ce que** les conducteurs plats (1, 2) définissent une forma de maillage en losanges ou en trapèzes,

20. Support d'information transportable selon l'une des revendications 1 à 19, **caractérisé en ce que** les conducteurs plats (1, 2) présentent des conducteurs chauffants (1h, 2h) intégrés.

21. Support d'information transportable selon l'une des revendications 1 à 20, **caractérisé en ce que** les conducteurs plats (1, 2) sont entourés par des conducteurs chauffants séparés placés sur l'extérieur.

22. Support d'information transportable selon l'une des revendications 1 à 21, **caractérisé en ce que** la matrice des conducteurs plats (1, 2) est conçue en forma d'éventail.

23. Support d'information transportable selon l'une des revendications 1 à 22, **caractérisé en ce que** la matrice des conducteurs plats est appliquée avec isolement électrique sur une feuille flexible fermée.

24. Support d'information transportable selon l'une des revendications 1 à 23, **caractérisé en ce que** les conducteurs plats (1, 2) se composent de torons à haute flexibilité.
